# EUROPÄISCHE PATENTSCHRIFT

(11) **EP 4 003 823 B1**
(45) Veröffentlichungstag und Bekanntmachung des Hinweises auf die Patenterteilung: **30.08.2023**
(21) Anmeldenummer: 20733228.9
(22) Anmeldetag: 10.06.2020
(51) Int. Cl.: B62D 65/04

(54) **VERFAHREN ZUM INITIALISIEREN EINES KRAFTFAHRZEUGS**
METHOD FOR INITIALIZING A MOTOR VEHICLE
PROCÉDÉ DE DÉMARRAGE D'UN VÉHICULE AUTOMOBILE

(30) Priorität: 26.07.2019 DE 102019211124
(43) Veröffentlichungstag der Anmeldung: 01.06.2022
(73) Patentinhaber: Robert Bosch GmbH, 70442 Stuttgart (DE)
(72) Erfinder: REINAUER, Anastasia, 76137 Karlsruhe (DE); NORDBRUCH, Stefan, 70806 Kornwestheim (DE); FRIEDRICH, Thorsten, 71717 Beilstein (DE); HAEGELE, Heiko, 74417 Gschwend (DE)
(86) Internationale Anmeldenummer: PCT/EP2020/066061
(87) Internationale Veröffentlichungsnummer: WO 2021/018454

(56) Entgegenhaltungen:
- DE-A1- 19 816 287
- US-A1- 2003 094 320

## Beschreibung

Die Erfindung betrifft ein Verfahren zum Initialisieren eines Kraftfahrzeugs. Die Erfindung betrifft weiter eine Vorrichtung, ein Rolling Chassis, eine Karosserie, ein Computerprogramm und ein maschinenlesbares Speichermedium.

### Stand der Technik

Ein Rolling Chassis bezeichnet in der Regel ein Chassis oder ein Fahrgestell umfassend einen Antriebsmotor und einen Antriebsstrang, sodass ein Rolling Chassis mit eigener Antriebskraft fahren kann.

Üblicherweise wird eine Karosserie auf ein solches Rolling Chassis angeordnet.

Ein Vorteil in der Verwendung eines Rolling Chassis liegt insbesondere darin, dass für ein Rolling Chassis mehrere mögliche Karosserien vorgesehen sein können, sodass unterschiedliche Kraftfahrzeuge effizient hergestellt werden können.

Hierbei kann das Rolling Chassis andere Funktionalitäten und/oder Komponenten aufweisen bzw. bereitstellen als die Karosserie.

Dadurch können zum Beispiel Funktionalitäten, die durch die Karosserie nicht zur Verfügung stehen, nicht durch das Rolling Chassis bedient werden. Beispielsweise können Funktionalitäten im Rolling Chassis nicht bedient und ausgeführt werden, weil zum Beispiel Daten aus der Karosserie nicht zur Verfügung stehen.

Es besteht ein Bedarf, diesen Umstand bei der Initialisierung eines Kraftfahrzeugs zu berücksichtigen. US 2003/094320 offenbart Verfahren zum Initialisieren eines Kraftfahrzeugs wobei das Kraftfahrzeug eine Anordnung aufweisend ein Rolling Chassis und eine am Rolling Chassis angeordnete Karosserie umfasst, das Verfahren umfassend die folgenden Schritte: Empfangen von Spezifikationssignalen, welche eine Spezifikation der Karosserie ("body pod") repräsentieren, wobei die zweite Spezifikation weiter Parameter für eine Parametrisierung der angegebenen Komponenten und/oder Funktionalitäten des Rolling Chassis angibt.

### Offenbarung der Erfindung

Die der Erfindung zugrunde liegende Aufgabe ist darin zu sehen, ein Konzept zum effizienten Initialisieren eines Kraftfahrzeugs bereitzustellen, wobei das Kraftfahrzeug eine Anordnung aufweisend ein Rolling Chassis und eine am Rolling Chassis angeordnete Karosserie umfasst.

Diese Aufgabe wird mittels des jeweiligen Gegenstands der unabhängigen Ansprüche gelöst. Vorteilhafte Ausgestaltungen der Erfindung sind Gegenstand von jeweils abhängigen Unteransprüchen.

Nach einem ersten Aspekt wird ein Verfahren zum Initialisieren eines Kraftfahrzeugs bereitgestellt, wobei das Kraftfahrzeug eine Anordnung aufweisend ein Rolling Chassis und eine am Rolling Chassis angeordnete Karosserie umfasst, umfassend die folgenden Schritte:
Empfangen von ersten Spezifikationssignalen, welche eine erste Spezifikation des Rolling Chassis repräsentieren, wobei die erste Spezifikation angibt, welche Komponenten und/oder welche Funktionalitäten alleine mittels des Rolling Chassis bereitgestellt werden können, wobei die erste Spezifikation weiter Parameter für eine Parametrisierung der angegebenen Komponenten und/oder Funktionalitäten des Rolling Chassis angibt,
Empfangen von zweiten Spezifikationssignalen, welche eine zweite Spezifikation der Karosserie repräsentieren, wobei die zweite Spezifikation angibt, welche Komponenten und/oder welche Funktionalitäten alleine mittels der Karosserie bereitgestellt werden können, wobei die zweite Spezifikation weiter Parameter für eine Parametrisierung der angegebenen Komponenten und/oder Funktionalitäten der Karosserie angibt,
Ermitteln basierend auf der ersten und zweiten Spezifikation, welche der Komponenten und/oder welche der Funktionalitäten des Rolling Chassis und der Karosserie mittels der Anordnung aus Rolling Chassis und Karosserie bereitgestellt werden können,
Erzeugen von Initialisierungssignalen, welche Initialisierungsdaten für eine Initialisierung des Kraftfahrzeugs repräsentieren, basierend auf der ersten und zweiten Spezifikation und
Ausgeben der erzeugten Initialisierungssignale, um das Kraftfahrzeug zu initialisieren.

Nach einem zweiten Aspekt wird eine Vorrichtung bereitgestellt, die eingerichtet ist, alle Schritte des Verfahrens nach dem ersten Aspekt auszuführen.

Nach einem dritten Aspekt wird ein Rolling Chassis bereitgestellt, welches die Vorrichtung nach dem zweiten Aspekt umfasst.

Nach einem vierten Aspekt wird eine Karosserie bereitgestellt, welche die Vorrichtung nach dem zweiten Aspekt umfasst.

Nach einem fünften Aspekt wird ein Kraftfahrzeug bereitgestellt, umfassend eine Anordnung aus einem Rolling Chassis und einer am Rolling Chassis angeordneten Karosserie und die Vorrichtung nach dem zweiten Aspekt.

Nach einem sechsten Aspekt wird ein Computerprogramm bereitgestellt, welches Befehle umfasst, die bei Ausführung des Computerprogramms durch einen Computer, beispielsweise durch die Vorrichtung nach dem zweiten Aspekt, diesen veranlassen, ein Verfahren gemäß dem ersten Aspekt auszuführen.

Nach einem siebten Aspekt wird ein maschinenlesbares Speichermedium bereitgestellt, auf dem das Computerprogramm nach dem sechsten Aspekt gespeichert ist.

Die Erfindung basiert auf der Erkenntnis und schließt diese mit ein, dass die obige Aufgabe dadurch gelöst werden kann, dass nach einem Anordnen der Karosserie auf dem Rolling Chassis automatisch folgende Aktionen durchgeführt werden:
Überprüfen, welche Komponenten und/oder Funktionalitäten im Rolling Chassis und welche Komponenten und/oder Funktionalitäten in der Karosserie zur Verfügung stehen;
Festlegen, welche Komponenten und/oder Funktionalitäten aus der Kombination aus Rolling Chassis und Karosserie zur Verfügung stehen; und
Initialisieren, insbesondere Parametrisieren, der Komponenten und/oder Funktionalitäten im Rolling Chassis und in der Karosserie entsprechend der Kombination aus Rolling Chassis und Karosserie.

Mit anderen Worten bedeutet dies, dass die obige Aufgabe dadurch gelöst werden kann, dass basierend auf der ersten und zweiten Spezifikation ermittelt wird, welche der Komponenten und/oder welche der Funktionalitäten des Rolling Chassis und der Karosserie mittels der Anordnung aus Rolling Chassis und Karosserie bereitgestellt werden können, wobei entsprechend einem Ergebnis dieses Ermittelns Initialisierungssignale erzeugt werden, welche Initialisierungsdaten für eine Initialisierung des Kraftfahrzeugs repräsentieren, basierend auf der ersten und zweiten Spezifikation.

Die Initialisierungsdaten bezeichnen also insbesondere Daten, welche sich eignen, das Kraftfahrzeug zu initialisieren.

Ein Initialisieren des Kraftfahrzeugs umfasst insbesondere ein Festlegen von zulässigen Fahreigenschaften, insbesondere Beschleunigung, Geschwindigkeiten, Kurvengeschwindigkeiten, Höchstgeschwindigkeiten.

Ein Initialisieren des Kraftfahrzeugs umfasst insbesondere ein Festlegen, ob ein Anhänger an das Kraftfahrzeug angehängt werden darf.

Ein Initialisieren des Kraftfahrzeugs umfasst insbesondere ein Festlegen von Bremseigenschaften.

Das Festlegen ist bezogen auf die Anordnung Rolling Chassis und Karosserie zu sehen, also für das Kraftfahrzeug. Denn so können sich die zulässigen Fahreigenschaften und/oder, ob ein Anhänger an das Kraftfahrzeug angehängt werden darf, und/oder die Bremseigenschaften von Kraftfahrzeug, zum Beispiel von einem Sport-Kraftfahrzeug umfassend eine Sport-Karosserie, zu Kraftfahrzeug, zum Beispiel von einem Sprinter-Kraftfahrzeug umfassend eine Sprinter-Karosserie, unterscheiden.

Somit wird also insbesondere der technische Vorteil bewirkt, dass das Kraftfahrzeug effizient initialisiert werden kann. Das heißt also insbesondere, dass dadurch in vorteilhafter Weise ein Konzept zum effizienten Initialisieren eines Kraftfahrzeugs bereitgestellt ist.

Weiter können in effizienter Weise unterschiedliche Karosserien für ein Rolling Chassis verwendet werden.

Nach einer Ausführungsform ist vorgesehen, dass das Verfahren automatisch nach einem Anordnen der Karosserie auf das Kraftfahrzeug durchgeführt oder ausgeführt wird.

Nach einer Ausführungsform ist vorgesehen, dass das Verfahren nach einem Anordnen der Karosserie auf das Rolling Chassis manuell initiiert wird.

Nach einer Ausführungsform ist das Verfahren nach dem ersten Aspekt ein computerimplementiertes Verfahren.

Gemäß einer Ausführungsform ist vorgesehen, dass Chassisspezifikationsanforderungssignale erzeugt und ausgegeben werden, welche eine Anforderung nach der ersten Spezifikation repräsentieren, so dass die ersten Spezifikationssignale in Reaktion auf das Ausgeben der Chassisspezifikationsanforderungssignale empfangen werden.

Dadurch wird zum Beispiel der technische Vorteil bewirkt, dass die erste Spezifikation effizient erhalten oder empfangen werden kann.

Gemäß einer Ausführungsform ist vorgesehen, dass Chassisidentifikationssignale empfangen werden, welche eine Chassisidentifikation des Rolling Chassis repräsentieren, wobei die Chassisspezifikationsanforderungssignale basierend auf der Chassisidentifikation erzeugt werden, so dass die Anforderung nach der ersten Spezifikation die Chassisidentifikation umfasst.

Dadurch wird zum Beispiel der technische Vorteil bewirkt, dass die erste Spezifikation effizient angefordert werden kann. Beispielsweise kann die Chassisidentifikation verwendet werden, um aus einer Datenbank umfassend mehrere Spezifikationen für mehrere Chassis die erste Spezifikation auszulesen.

Nach einer Ausführungsform ist vorgesehen, dass Karosseriespezifikationsanforderungssignale erzeugt und ausgegeben werden, welche eine Anforderung nach der zweiten Spezifikation repräsentieren, so dass die zweiten Spezifikationssignale in Reaktion auf das Ausgeben der Karosseriespezifikationsanforderungssignale empfangen werden.

Dadurch wird zum Beispiel der technische Vorteil bewirkt, dass die zweite Spezifikation effizient erhalten oder empfangen werden kann.

Nach einer Ausführungsform ist vorgesehen, dass Karosserieidentifikationssignale empfangen werden, welche eine Karosserieidentifikation der Karosserie repräsentieren, wobei die Karosseriespezifikationsanforderungssignale basierend auf der Karosserieidentifikation erzeugt werden, so dass die Anforderung nach der zweiten Spezifikation die Karosserieidentifikation umfasst.

Dadurch wird zum Beispiel der technische Vorteil bewirkt, dass die zweite Spezifikation effizient angefordert werden kann. Beispielsweise kann die Karosserieidentifikation verwendet werden, um aus einer Datenbank umfassend mehrere Spezifikationen für mehrere Karosserien die zweite Spezifikation auszulesen.

Nach einer Ausführungsform ist vorgesehen, dass das Ausgeben der Anforderungssignale nach der entsprechenden Spezifikation ein Senden der Anforderungssignale an einen lokalen Speicher und/oder ein Senden der Anforderungssignale über ein Kommunikationsnetzwerk an einen entfernten Spezifikationsserver umfasst.

Dadurch wird zum Beispiel der technische Vorteil bewirkt, dass die entsprechende Spezifikation effizient erhalten oder empfangen werden kann.

Die Anforderungssignale in dieser Ausführungsform stehen für die Karosseriespezifikationsanforderungssignale und/oder für die Chassisspezifikationsanforderungssignale als generischer Oberbegriff.

Ein Kommunikationsnetzwerk im Sinne der Beschreibung umfasst zum Beispiel ein WLAN-Kommunikationsnetzwerk und/oder ein Mobilfunknetz.

Ein lokaler Speicher ist zum Beispiel in der Vorrichtung integriert bzw. von dieser umfasst.

Ein lokaler Speicher ist zum Beispiel von der Karosserie, von dem Rolling Chassis und/oder von dem Kraftfahrzeug umfasst.

Nach einer Ausführungsform ist vorgesehen, dass die Initialisierungsdaten Parameter für eine jeweilige Parametrisierung der ermittelten Komponenten und/oder Funktionalitäten und/oder Funktionszustandsdaten umfassen, welche angeben, welche Komponenten und/oder Funktionalitäten zur Benutzung freigeschaltet werden dürfen.

Dadurch wird zum Beispiel der technische Vorteil bewirkt, dass die ermittelten Komponenten und/oder Funktionalitäten effizient parametrisiert werden können. Weiter wird dadurch zum Beispiel der technische Vorteil bewirkt, dass effizient angegeben werden kann, welche Komponenten und/oder Funktionalitäten zur Benutzung freigeschaltet werden dürfen.

Ein Parametrisieren umfasst zum Beispiel ein Festlegen, in welcher Position, insbesondere Höhe, ein Sensor, insbesondere ein Umfeldsensor, insbesondere eine Videokamera umfassend einen Videosensor, an der Karosserie angeordnet ist. Dies ist zum Beispiel für einen Sprinter und ein Cabrio unterschiedlich. Somit kann zum Beispiel der Umstand, dass Sensoren bei unterschiedlichen Karosserien an unterschiedlichen Positionen angeordnet sein können, effizient berücksichtigt werden.

Ein Parametrisieren umfasst zum Beispiel ein Festlegen von Motoreinstellungen eines Antriebsmotors des Rolling Chassis. Das heißt, es wird insbesondere festgelegt, welche Motoreinstellungen aufgrund des Aufbaus sinnvoll und/oder notwendig und/oder vorgeschrieben sind.

Ein Parametrisieren umfasst zum Beispiel ein Festlegen eines Bremsverhaltens. Das heißt, es wird insbesondere ermittelt, wie sich das Kraftfahrzeug verhält, wobei basierend auf dem Verhalten festgelegt wird, wie gebremst werden muss. Zum Beispiel hat ein Sprinter einen anderen Schwerpunkt als ein PKW (Personenkraftwagen). Daher muss anders gebremst werden. Zum Beispiel muss sich ein ESP (Elektronisches Stabilitätsprogramm) anders verhalten. Da heißt also insbesondere, dass ein Festlegen eines Bremsverhaltens ein Festlegen von ESP-Parametern umfasst.

Nach einer Ausführungsform ist vorgesehen, dass ein oder mehrere Verfahrensschritte und/oder zumindest einige, insbesondere alle, Initialisierungsdaten dokumentiert werden, insbesondere in einer Blockchain dokumentiert werden.

Dadurch wird zum Beispiel der technische Vorteil bewirkt, dass auch nach Durchführung des Verfahrens aufgrund der Dokumentation effizient nachvollzogen werden kann, wie das Verfahren im Einzelnen abgelaufen ist. Das Verwenden einer Blockchain für das Dokumentieren weist insbesondere den technischen Vorteil auf, dass die Schritte manipulationssicher dokumentiert werden können.

Nach einer Ausführungsform ist vorgesehen, dass vor dem Ausgeben der erzeugten Initialisierungssignale, um das Kraftfahrzeug zu initialisieren, die Initialisierungsdaten für eine Überprüfung an eine entfernte Überprüfungseinrichtung über ein Kommunikationsnetzwerk gesendet werden, wobei in Reaktion auf das Senden der Initialisierungsdaten an die entfernte Überprüfungseinrichtung, Ergebnissignale empfangen werden, welche ein Ergebnis der Überprüfung durch die entfernte Überprüfungseinrichtung repräsentieren, wobei abhängig von dem Ergebnis die erzeugten Initialisierungssignale ausgegeben werden oder die Initialisierungsdaten basierend auf dem Ergebnis überarbeitet werden, so dass überarbeitete Initialisierungssignale erzeugt und ausgegeben werden, welche die überarbeiteten Initialisierungsdaten repräsentieren.

Dadurch wird zum Beispiel der technische Vorteil bewirkt, dass eine effiziente Überprüfung der Initialisierungsdaten durchgeführt werden kann.

Eine entfernte Überprüfungseinrichtung umfasst zum Beispiel einen Hersteller des Rolling Chassis und/oder einen Hersteller der Karosserie und/oder den TÜV ("Technischer Überwachungsverein").

Zum Beispiel ist vorgesehen, dass vor einem Empfang des Ergebnisses ein Betrieb des Kraftfahrzeugs gesperrt ist.

Somit kann zum Beispiel in effizienter Weise und vorteilhafterweise sichergestellt werden, dass vor einem Betrieb des Kraftfahrzeugs die Initialisierungsdaten überprüft werden können.

Das Ergebnis der entfernten Überprüfungseinrichtung kann zum Beispiel angeben, dass die Initialisierungsdaten fehlerfrei sind.

In diesem Fall ist dann zum Beispiel vorgesehen, dass die erzeugten Initialisierungssignale ausgegeben werden.

Das Ergebnis der entfernten Überprüfungseinrichtung kann zum Beispiel angeben, dass die Initialisierungsdaten Fehler aufweisen. In diesem Fall kann zum Beispiel vorgesehen sein, dass das Überarbeiten der Initialisierungssignale umfasst, dass die Fehler korrigiert werden.

Das Ergebnis der entfernten Überprüfungseinrichtung kann zum Beispiel angeben, dass eine oder mehrere Komponenten und/oder eine oder mehrere Funktionalitäten nur eingeschränkt oder gar nicht zur Verfügung gestellt werden dürfen. In diesem Fall umfasst das Überarbeiten der Initialisierungsdaten zum Beispiel ein Überarbeiten der entsprechenden Parameter und/oder der Funktionszustandsdaten basierend auf diesem Ergebnis.

Nach einer Ausführungsform ist vorgesehen, dass das Verfahren nach dem ersten Aspekt mittels der Vorrichtung nach dem zweiten Aspekt ausgeführt wird.

Technische Funktionalitäten der Vorrichtung gemäß dem zweiten Aspekt ergeben sich in analoger Weise aus entsprechenden technischen Funktionalitäten des Verfahrens nach dem ersten Aspekt und umgekehrt.

Das heißt also insbesondere, dass sich Vorrichtungsmerkmale aus entsprechenden Verfahrensmerkmalen und umgekehrt ergeben.

Ein Chassis im Sinne der Beschreibung ist ein Kraftfahrzeugchassis. Das heißt also, dass ein Rolling Chassis ein Kraftfahrzeugchassis ist.

Eine Karosserie im Sinne der Beschreibung ist eine Kraftfahrzeugkarosserie.

Im Englischen können für den Begriff Karosserie der Begriff "Body" oder der Begriff "Top Hat" verwendet werden. Daraus folgt, dass anstelle des Begriffs "Karosserie" im Deutschen auch der Begriff "Aufbau" verwendet werden kann.

Der Begriff "Karosserie" bzw. "Kraftfahrzeugkarosserie" kann gemäß einer Ausführungsform breit ausgelegt werden. So kann gemäß einer Ausführungsform die Karosserie zum Beispiel eine oder mehrere der folgenden Komponenten umfassen: Kraftfahrzeugsitz, Armaturenbrett, Schalthebel, Kraftfahrzeugfenster, Kraftfahrzeugtür, Kraftfahrzeuginnenraumausstattung, Airbag, Assistenzsystem, Videokamera, Mensch-Maschinen-Schnittstelle Tachometer.

Mit Karosserie kann somit im Sinne dieser Beschreibung der obere Teil ("Top Hat") eines Kraftfahrzeugs bezeichnet werden, welcher auf einem Chassis angeordnet ist. Die Karosserie kann somit analog zu einem Fertigbauteil eines Fertighauses bereits ein soweit gefertigtes Bauteil sein, dass nach einem Anordnen der Karosserie auf das Rolling Chassis ein fertiges Kraftfahrzeug, also insbesondere ein fahrbereites Kraftfahrzeug, gebildet ist.

Ein Rolling Chassis umfasst gemäß einer Ausführungsform eine oder mehrere der folgenden Komponenten: Rad, Achse, Antriebsmotor, Lenkung, Bremse, Rahmen, Thermokomponenten, Batterie, Batteriegehäuse, Sensor, insbesondere Umfeldsensor (zum Beispiel: Radarsensor, Lidarsensor, Ultraschallsensor, Magnetfeldsensor, Infrarotsensor, Videosensor), Steuergerät (Im Englischen "ECU" ("Electronic control unit") genannt.) PC (Personal Computer).

Das Rolling Chassis kann somit gemäß einer Ausführungsform analog zu einem Fertigbauteil eines Fertighauses bereits ein soweit gefertigtes Bauteil sein, dass nach einem Anordnen der Karosserie auf das Rolling Chassis ein fertiges Kraftfahrzeug, also insbesondere ein fahrbereites Kraftfahrzeug, gebildet ist.

Das Rolling Chassis bezeichnet somit insbesondere das untere Bauteil bezogen auf das obere Bauteil (Karosserie). Somit ist also gemäß einer Ausführungsform durch die Anordnung aus oberen Bauteil (Karosserie) und unterem Bauteil (Rolling Chassis), wobei das obere Bauteil auf dem unteren Bauteil angeordnet ist, ein fertiges Kraftfahrzeug, also insbesondere ein fahrbereites Kraftfahrzeug, gebildet.

Ausführungsbeispiele der Erfindung sind in den Zeichnungen dargestellt und in der nachfolgenden Beschreibung näher erläutert.

Es zeigen:
- Fig. 1: ein Ablaufdiagramm eines Verfahrens zum Initialisieren eines Kraftfahrzeugs,
- Fig. 2: eine Vorrichtung,
- Fig. 3: ein maschinenlesbares Speichermedium,
- Fig. 4: ein erstes Rolling Chassis und
- Fig. 5: ein zweites Rolling Chassis sowie zwei unterschiedliche Karosserien.

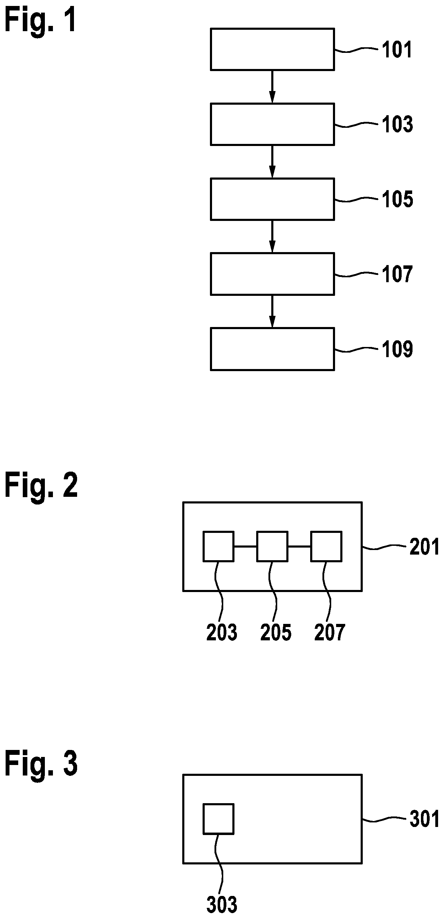

Fig. 1 zeigt ein Ablaufdiagramm eines Verfahrens zum Initialisieren eines Kraftfahrzeugs, wobei das Kraftfahrzeug eine Anordnung aufweisend ein Rolling Chassis und eine am Rolling Chassis angeordnete Karosserie umfasst, umfassend die folgenden Schritte:
Empfangen 101 von ersten Spezifikationssignalen, welche eine erste Spezifikation des Rolling Chassis repräsentieren, wobei die erste Spezifikation angibt, welche Komponenten und/oder welche Funktionalitäten alleine mittels des Rolling Chassis bereitgestellt werden können, wobei die erste Spezifikation weiter Parameter für eine Parametrisierung der angegebenen Komponenten und/oder Funktionalitäten des Rolling Chassis angibt,
Empfangen 103 von zweiten Spezifikationssignalen, welche eine zweite Spezifikation der Karosserie repräsentieren, wobei die zweite Spezifikation angibt, welche Komponenten und/oder welche Funktionalitäten alleine mittels der Karosserie bereitgestellt werden können, wobei die zweite Spezifikation weiter Parameter für eine Parametrisierung der angegebenen Komponenten und/oder Funktionalitäten der Karosserie angibt,
Ermitteln 105 basierend auf der ersten und zweiten Spezifikation, welche der Komponenten und/oder welche der Funktionalitäten des Rolling Chassis und der Karosserie mittels der Anordnung aus Rolling Chassis und Karosserie bereitgestellt werden können,
Erzeugen 107 von Initialisierungssignalen, welche Initialisierungsdaten für eine Initialisierung des Kraftfahrzeugs repräsentieren, basierend auf der ersten und zweiten Spezifikation und
Ausgeben 109 der erzeugten Initialisierungssignale, um das Kraftfahrzeug zu initialisieren.

Nach einer Ausführungsform ist vorgesehen, dass die Karosserie automatisch alle Informationen, also welche Komponenten vorhanden sind, welche Funktionalitäten mit der Karosserie möglich sind, was die Parametrisierungen im Rolling Chassis für die Karosserie sind, an das Rolling Chassis überträgt oder übermittelt. Das heißt also, dass die Karosserie automatisch die zweite Spezifikation der Karosserie bereitstellt.

In einer anderen Ausführungsform ist vorgesehen, dass das Rolling Chassis die zweite Spezifikation von der Karosserie abfragt.

In einer Ausführungsform ist vorgesehen, dass die in der Karosserie gespeicherte zweite Spezifikation über eine Zeit aktualisiert wird. Dies kann zum Beispiel in einer Werkstatt offline durchgeführt werden oder online, zum Beispiel aus einer Cloud-Infrastruktur durchgeführt werden, oder kann durch einen Endkunden selbst durchgeführt werden.

In einer Ausführungsform ist in der Karosserie eine Karosserieidentifikation gespeichert. Diese Karosserieidentifikation wird gemäß einer Ausführungsform automatisch an das Rolling Chassis übermittelt und/oder von dem Rolling Chassis von der Karosserie abgefragt.

Über die Karosserieidentifikation kann nach einer Ausführungsform das Rolling Chassis die zweite Spezifikation abrufen und die entsprechenden Funktionalitäten und Komponenten konfigurieren, also insbesondere parametrisieren, und, wenn notwendig, auch freischalten.

In einer Ausführungsform ist vorgesehen, dass die zweite Spezifikation im Rolling Chassis gespeichert ist. Nach einer Ausführungsform können diese Daten, also die zweite Spezifikation, im Rolling Chassis über eine Zeit aktualisiert werden. Zum Beispiel in einer Werkstatt oder online zum Beispiel aus einer Cloud und/oder durch einen Endkunden selbst.

In einer Ausführungsform ist die zweite Spezifikation extern gespeichert, zum Beispiel in einer Cloud-Infrastruktur. Das Rolling Chassis fragt gemäß einer Ausführungsform die zweite Spezifikation aus der Cloud-Infrastruktur an.

Nach einer Ausführungsform ist vorgesehen, dass die Daten in der Cloud-Infrastruktur, also die zweite Spezifikation, über eine Zeit aktualisiert wird, zum Beispiel durch einen Hersteller (OEM).

In einer Ausführungsform werden die Funktionszustände (Freischaltungen) sowie Parametrisierungen dokumentiert, da hierbei auch sicherheitskritische Veränderungen durchgeführt werden können, die allerdings im Vorfeld zum Beispiel von einem Hersteller freigegeben wurden. Nach einer Ausführungsform wird das Dokumentieren auf einer oder mehreren fälschungssicheren Methoden durchgeführt, zum Beispiel mit Blockchain-Mechanismen.

Nach einer Ausführungsform ist vorgesehen, dass die Funktionszustände (Freischaltungen) sowie Parametrisierungen zusätzlich zu einer Überprüfungsanalyse zu einem dafür zuständigen Überprüfer (entfernte Überprüfungseinrichtung) (zum Beispiel OEM; TÜV) gesendet und erst nach dessen Freigabe wird das Rolling Chassis mit der Karosserie freigeschaltet. Das heißt also insbesondere, dass vorher zum Beispiel keine Fahrt und/oder Benutzung der Anordnung aus Rolling Chassis und Karosserie möglich ist.

Fig. 2 zeigt eine Vorrichtung 201.

Die Vorrichtung 201 ist eingerichtet, alle Schritte des Verfahrens nach dem ersten Aspekt auszuführen.

Die Vorrichtung 201 umfasst einen Eingang 203, welcher eingerichtet ist, die ersten Spezifikationssignale und die zweiten Spezifikationssignale zu empfangen.

Die Vorrichtung 201 umfasst weiter einen Prozessor 205, welcher eingerichtet ist, zu ermitteln basierend auf der ersten und zweiten Spezifikation, welche der Komponenten und/oder welche der Funktionalitäten das Rolling Chassis und der Karosserie mittels der Anordnung aus Rolling Chassis und Karosserie bereitgestellt werden können.

Der Prozessor 205 ist weiter eingerichtet, die Initialisierungssignale zu erzeugen basierend auf der ersten und zweiten Spezifikation.

Die Vorrichtung 201 umfasst weiter einen Ausgang 207, welcher eingerichtet ist, die erzeugten Initialisierungssignale auszugeben, um das Kraftfahrzeug zu initialisieren.

In einer nicht gezeigten Ausführungsform umfasst die Vorrichtung 201 anstelle des einen Prozessors 205 mehrere Prozessoren.

Signale, welche empfangen werden, werden insbesondere mittels des Eingangs 203 empfangen. Der Eingang 203 ist also eingerichtet, die entsprechenden Signale zum empfangen.

Signale, die ausgegeben werden, werden insbesondere mittels des Ausgangs 207 ausgegeben. Das heißt also insbesondere, dass der Ausgang 207 entsprechend eingerichtet ist, die entsprechenden Signale auszugeben.

Signale, welche erzeugt werden, werden insbesondere mittels des Prozessors 205 erzeugt. Der Prozessor 205 ist also insbesondere eingerichtet, die entsprechenden Signale zu erzeugen.

Fig. 3 zeigt ein maschinenlesbares Speichermedium 301.

Auf dem maschinenlesbaren Speichermedium 301 ist ein Computerprogramm 303 gespeichert. Das Computerprogramm 303 umfasst Befehle, die bei Ausführung des Computerprogramms 303 durch einen Computer diesen veranlassen, ein Verfahren gemäß dem ersten Aspekt auszuführen.

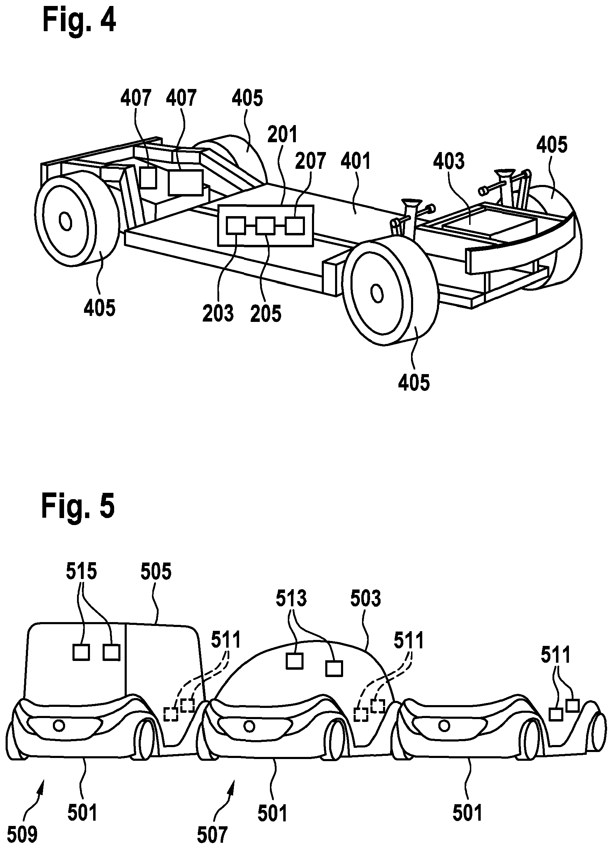

Fig. 4 zeigt ein erstes Rolling Chassis 401.

Das Rolling Chassis 401 umfasst einen Antriebsmotor 403 und vier Räder 405.

Weiter umfasst das Rolling Chassis 401 mehrere Komponenten 407. Bei den Komponenten 407 kann es sich zum Beispiel um eine oder mehrere der vorstehend bezeichneten Komponenten handeln, welche im Zusammenhang mit dem Rolling Chassis beschrieben wurden.

Weiter umfasst das Rolling Chassis 401 die Vorrichtung 201 gemäß Fig. 2.

Fig. 5 zeigt dreimal ein gleiches zweites Rolling Chassis 501 umfassend mehrere Komponenten 511. Bei den Komponenten 511 kann es sich zum Beispiel um eine oder mehrere der vorstehend bezeichneten Komponenten handeln, welche im Zusammenhang mit dem Rolling Chassis beschrieben wurden.

Ganz rechts in der Fig. 5 ist ein zweites Rolling Chassis 501 ohne Karosserie gezeigt.

Ganz links und in der Mitte ist jeweils ein zweites Rolling Chassis 501 mit einer unterschiedlichen Karosserie 503, 505 (erste Karosserie 503 und zweite Karosserie 505) gezeigt, wobei die entsprechenden Karosserien 503, 505 auf den entsprechenden Rolling Chassis 501 angeordnet sind.

Die erste Karosserie 503 umfasst mehrere Komponenten 513.

Die zweite Karosserie 505 umfasst mehrere Komponenten 515.

Bei den Komponenten 513 und 515 kann es sich zum Beispiel um eine oder mehrere der vorstehend bezeichneten Komponenten handeln, welche im Zusammenhang mit der Karosserie beschrieben wurden.

Somit sind also in Fig. 5 zwei Kraftfahrzeuge gezeigt: ein erstes Kraftfahrzeug 507 umfassend die Anordnung aus zweitem Rolling Chassis 501 und der ersten Karosserie 503 sowie ein zweites Kraftfahrzeug 509 umfassend eine Anordnung aus zweitem Rolling Chassis 501 und der zweiten Karosserie 505.

Es kann gemäß einer Ausführungsform vorgesehen sein, dass das Rolling Chassis 501 die Vorrichtung 201 gemäß Fig. 2 umfasst.

Nach einer Ausführungsform kann vorgesehen sein, dass zusätzlich oder anstelle zum Rolling Chassis 501 auch die beiden Karosserien 503, 505 die Vorrichtung 201 gemäß Fig. 2 umfassen.

Nach dem Anordnen der Karosserien 503, 505 auf das entsprechende Rolling Chassis 501 ist gemäß einer Ausführungsform vorgesehen, dass das Verfahren nach dem ersten Aspekt automatisch durchgeführt wird.

Somit können in vorteilhafter und effizienter Weise die beiden Kraftfahrzeuge 507, 509 effizient initialisiert werden.

## Patentansprüche

1. Verfahren zum Initialisieren eines Kraftfahrzeugs (507, 509), wobei das Kraftfahrzeug (507, 509) eine Anordnung aufweisend ein Rolling Chassis (401, 501) und eine am Rolling Chassis (401, 501) angeordnete Karosserie (503, 505) umfasst, umfassend die folgenden Schritte:
Empfangen (101) von ersten Spezifikationssignalen, welche eine erste Spezifikation des Rolling Chassis (401, 501) repräsentieren, wobei die erste Spezifikation angibt, welche Komponenten und/oder welche Funktionalitäten alleine mittels des Rolling Chassis (401, 501) bereitgestellt werden können, wobei die erste Spezifikation weiter Parameter für eine Parametrisierung der angegebenen Komponenten und/oder Funktionalitäten des Rolling Chassis (401, 501) angibt,
Empfangen (103) von zweiten Spezifikationssignalen, welche eine zweite Spezifikation der Karosserie (503, 505) repräsentieren, wobei die zweite Spezifikation angibt, welche Komponenten und/oder welche Funktionalitäten alleine mittels der Karosserie (503, 505) bereitgestellt werden können, wobei die zweite Spezifikation weiter Parameter für eine Parametrisierung der angegebenen Komponenten und/oder Funktionalitäten der Karosserie (503, 505) angibt,
Ermitteln (105) basierend auf der ersten und zweiten Spezifikation, welche der Komponenten und/oder welche der Funktionalitäten des Rolling Chassis (401, 501) und der Karosserie (503, 505) mittels der Anordnung aus Rolling Chassis (401, 501) und Karosserie (503, 505) bereitgestellt werden können,
Erzeugen (107) von Initialisierungssignalen, welche Initialisierungsdaten für eine Initialisierung des Kraftfahrzeugs (507, 509) repräsentieren, basierend auf der ersten und zweiten Spezifikation und
Ausgeben (109) der erzeugten Initialisierungssignale, um das Kraftfahrzeug (507, 509) zu initialisieren.

2. Verfahren nach Anspruch 1, wobei Chassisspezifikationsanforderungssignale erzeugt und ausgegeben werden, welche eine Anforderung nach der ersten Spezifikation repräsentieren, so dass die ersten Spezifikationssignale in Reaktion auf das Ausgeben der Chassisspezifikationsanforderungssignale empfangen werden.

3. Verfahren nach Anspruch 2, wobei Chassisidentifikationssignale empfangen werden, welche eine Chassisidentifikation des Rolling Chassis (401, 501) repräsentieren, wobei die Chassisspezifikationsanforderungssignale basierend auf der Chassisidentifikation erzeugt werden, so dass die Anforderung nach der ersten Spezifikation die Chassisidentifikation umfasst.

4. Verfahren nach einem der vorherigen Ansprüche, wobei Karosseriespezifikationsanforderungssignale erzeugt und ausgegeben werden, welche eine Anforderung nach der zweiten Spezifikation repräsentieren, so dass die zweiten Spezifikationssignale in Reaktion auf das Ausgeben der Karosseriespezifikationsanforderungssignale empfangen werden.

5. Verfahren nach Anspruch 4, wobei Karosserieidentifikationssignale empfangen werden, welche eine Karosserieidentifikation der Karosserie (503, 505) repräsentieren, wobei die Karosseriespezifikationsanforderungssignale basierend auf der Karosserieidentifikation erzeugt werden, so dass die Anforderung nach der zweiten Spezifikation die Karosserieidentifikation umfasst.

6. Verfahren nach einem der Ansprüche 2 bis 5, wobei das Ausgeben der Anforderungssignale nach der entsprechenden Spezifikation ein Senden der Anforderungssignale an einen lokalen Speicher und/oder ein Senden der Anforderungssignale über ein Kommunikationsnetzwerk an einen entfernten Spezifikationsserver umfasst.

7. Verfahren nach einem der vorherigen Ansprüche, wobei die Initialisierungsdaten Parameter für eine jeweilige Parametrisierung der ermittelten Komponenten und/oder Funktionalitäten und/oder Funktionszustandsdaten umfassen, welche angeben, welche Komponenten und/oder Funktionalitäten zur Benutzung freigeschaltet werden dürfen.

8. Verfahren nach einem der vorherigen Ansprüche, wobei ein oder mehrere Verfahrensschritte und/oder zumindest einige, insbesondere alle, Initialisierungsdaten dokumentiert werden, insbesondere in einer Blockchain dokumentiert werden.

9. Verfahren nach einem der vorherigen Ansprüche, wobei vor dem Ausgeben der erzeugten Initialisierungssignale, um das Kraftfahrzeug (507, 509) zu initialisieren, die Initialisierungsdaten für eine Überprüfung an eine entfernte Überprüfungseinrichtung über ein Kommunikationsnetzwerk gesendet werden, wobei in Reaktion auf das Senden der Initialisierungsdaten an die entfernte Überprüfungseinrichtung, Ergebnissignale empfangen werden, welche ein Ergebnis der Überprüfung durch die entfernte Überprüfungseinrichtung repräsentieren, wobei abhängig von dem Ergebnis die erzeugten Initialisierungssignale ausgegeben werden oder die Initialisierungsdaten basierend auf dem Ergebnis überarbeitet werden, so dass überarbeitete Initialisierungssignale erzeugt und ausgegeben werden, welche die überarbeiteten Initialisierungsdaten repräsentieren.

10. Vorrichtung (201), die eingerichtet ist, alle Schritte des Verfahrens nach einem der vorherigen Ansprüche auszuführen.

11. Rolling Chassis (401, 501), umfassend die Vorrichtung (201) nach Anspruch 10.

12. Karosserie (503, 505), umfassend die Vorrichtung (201) nach Anspruch 10.

13. Kraftfahrzeug (507, 509), umfassend eine Anordnung aus einem Rolling Chassis (401, 501) und einer am Rolling Chassis (401, 501) angeordneten Karosserie (503, 505) und die Vorrichtung (201) nach Anspruch 10.

14. Computerprogramm (303), umfassend Befehle, die bei Ausführung des Computerprogramms (303) durch einen Computer diesen veranlassen, ein Verfahren gemäß einem der Ansprüche 1 bis 9 auszuführen.

15. Maschinenlesbares Speichermedium (301), auf dem das Computerprogramm (303) nach Anspruch 14 gespeichert ist.

## Claims

1. Method for initializing a motor vehicle (507, 509), wherein the motor vehicle (507, 509) comprises an arrangement having a rolling chassis (401, 501) and a vehicle body (503, 505) arranged on the rolling chassis (401, 501), comprising the following steps:
receiving (101) first specification signals which represent a first specification of the rolling chassis (401, 501), wherein the first specification indicates which components and/or which functionalities can be provided solely by means of the rolling chassis (401, 501), wherein the first specification furthermore indicates parameters for parameterizing the indicated components and/or functionalities of the rolling chassis (401, 501),
receiving (103) second specification signals which represent a second specification of the vehicle body (503, 505), wherein the second specification indicates which components and/or which functionalities can be provided solely by means of the vehicle body (503, 505), wherein the second specification furthermore indicates parameters for parameterizing the indicated components and/or functionalities of the vehicle body (503, 505),
determining (105) on the basis of the first and second specification which of the components and/or which of the functionalities of the rolling chassis (401, 501) and of the vehicle body (503, 505) can be provided by means of the arrangement consisting of rolling chassis (401, 501) and vehicle body (503, 505),
generating (107) initialization signals, which represent initialization data for initializing the motor vehicle (507, 509), on the basis of the first and second specification, and
outputting (109) the generated initialization signals in order to initialize the motor vehicle (507, 509).

2. Method according to Claim 1, wherein chassis specification demand signals are generated and output which represent a demand for the first specification, and therefore the first specification signals are received in response to the outputting of the chassis specification demand signals.

3. Method according to Claim 2, wherein chassis identification signals are received which represent a chassis identification of the rolling chassis (401, 501), wherein the chassis specification demand signals are generated on the basis of the chassis identification, and therefore the demand for the first specification comprises the chassis identification.

4. Method according to any one of the preceding claims, wherein vehicle body specification demand signals are generated and output which represent a demand for the second specification, and therefore the second specification signals are received in response to the outputting of the vehicle body specification demand signals.

5. Method according to Claim 4, wherein vehicle body identification signals are received which represent a vehicle body identification of the vehicle body (503, 505), wherein the vehicle body specification demand signals are generated on the basis of the vehicle body identification, and therefore the demand for the second specification comprises the vehicle body identification.

6. Method according to any one of Claims 2 to 5, wherein the outputting of the demand signals for the corresponding specification comprises sending the demand signals to a local memory and/or sending the demand signals via a communication network to a remote specification server.

7. Method according to any one of the preceding claims, wherein the initialization data comprise parameters for a respective parameterizing of the determined components and/or functionalities and/or function state data which indicate which components and/or functionalities may be enabled for use.

8. Method according to any one of the preceding claims, wherein one or more method steps and/or at least some, in particular all, initialization data are documented, in particular are documented in a blockchain.

9. Method according to any one of the preceding claims, wherein, prior to the outputting of the generated initialization signals in order to initialize the motor vehicle (507, 509), the initialization data are sent for checking to a remote checking facility via a communication network, wherein, in response to the sending of the initialization data to the remote checking facility, result signals are received which represent a result of the checking by the remote checking facility, wherein, depending on the result, the generated initialization signals are output or the initialization data are revised on the basis of the result, such that revised initialization signals are generated and output which represent the revised initialization data.

10. Device (201) which is configured to execute all of the steps of the method according to any one of the preceding claims.

11. Rolling chassis (401, 501) comprising the device (201) according to Claim 10.

12. Vehicle body (503, 505) comprising the device (201) according to Claim 10.

13. Motor vehicle (507, 509) comprising an arrangement consisting of a rolling chassis (401, 501) and a vehicle body (503, 505) arranged on the rolling chassis (401, 501), and the device (201) according to Claim 10.

14. Computer program (303) comprising commands which, when the computer program (303) is executed by a computer, cause said computer to execute a method according to any one of Claims 1 to 9.

15. Machine-readable memory medium (301) on which the computer program (303) according to Claim 14 is stored.

## Revendications

1. Procédé permettant d'initialiser un véhicule automobile (507, 509), dans lequel le véhicule automobile (507, 509) comprend un agencement présentant un châssis roulant (401, 501) et une carrosserie (503, 505) disposée sur le châssis roulant (401, 501), comprenant les étapes suivantes consistant à :
recevoir (101) des premiers signaux de spécification qui représentent une première spécification du châssis roulant (401, 501), dans lequel la première spécification indique les composants et/ou les fonctions pouvant être fournis uniquement au moyen du châssis roulant (401, 501), dans lequel la première spécification indique en outre des paramètres pour un paramétrage des composants et/ou fonctionnalités indiqués du châssis roulant (401, 501),
recevoir (103) des deuxièmes signaux de spécification qui représentent une deuxième spécification de la carrosserie (503, 505), dans lequel la deuxième spécification indique les composants et/ou les fonctionnalités qui peuvent être fournis uniquement au moyen de la carrosserie (503, 505), dans lequel la deuxième spécification indique en outre des paramètres pour un paramétrage des composants et/ou fonctionnalités indiqués de la carrosserie (503, 505),
déterminer (105) sur la base de la première et de la deuxième spécification ceux des composants et/ou celles des fonctionnalités du châssis roulant (401, 501) et de la carrosserie (503, 505) qui peuvent être fournis au moyen de l'agencement composé du châssis roulant (401, 501) et de la carrosserie (503, 505),
générer (107) des signaux d'initialisation qui représentent des données d'initialisation pour une initialisation du véhicule automobile (507, 509) sur la base de la première et de la deuxième spécification, et
sortir (109) les signaux d'initialisation générés pour initialiser le véhicule automobile (507, 509).

2. Procédé selon la revendication 1, dans lequel des signaux de demande de spécification de châssis sont générés et sortis qui représentent une demande de la première spécification de sorte que les premiers signaux de spécification sont reçus en réponse à la sortie des signaux de demande de spécification de châssis.

3. Procédé selon la revendication 2, dans lequel des signaux d'identification de châssis sont reçus qui représentent une identification de châssis du châssis roulant (401, 501), dans lequel les signaux de demande de spécification de châssis sont générés sur la base de l'identification de châssis de sorte que la demande de la première spécification comprend l'identification de châssis.

4. Procédé selon l'une quelconque des revendications précédentes, dans lequel des signaux de demande de spécification de carrosserie sont générés et sortis qui représentent une demande de la deuxième spécification de sorte que les deuxièmes signaux de spécification sont reçus en réponse à la sortie des signaux de demande de spécification de carrosserie.

5. Procédé selon la revendication 4, dans lequel des signaux d'identification de carrosserie sont reçus qui représentent une identification de carrosserie de la carrosserie (503, 505), dans lequel les signaux de demande de spécification de carrosserie sont générés sur la base de l'identification de carrosserie de sorte que la demande de la deuxième spécification comprend l'identification de carrosserie.

6. Procédé selon l'une quelconque des revendications 2 à 5, dans lequel la sortie des signaux de demande de la spécification correspondante comprend un envoi des signaux de demande à une mémoire locale et/ou un envoi des signaux de demande par un réseau de communication à un serveur de spécification distant.

7. Procédé selon l'une quelconque des revendications précédentes, dans lequel les données d'initialisation comprennent des paramètres pour un paramétrage respectif des composants et/ou fonctionnalités déterminés et/ou des données d'état de fonctionnement qui indiquent les composants et/ou fonctionnalités pouvant être validés en vue de leur utilisation.

8. Procédé selon l'une quelconque des revendications précédentes, dans lequel une ou plusieurs étapes de procédé et/ou au moins certaines, en particulier toutes les données d'initialisation sont documentées, en particulier dans une chaîne de blocs.

9. Procédé selon l'une quelconque des revendications précédentes, dans lequel avant la sortie des signaux d'initialisation générés pour initialiser le véhicule automobile (507, 509), les données d'initialisation sont envoyées pour vérification à un dispositif de vérification distant à travers un réseau de communication, dans lequel en réponse à l'envoi des données d'initialisation au dispositif de vérification distant, des signaux de résultat sont reçus qui représentent un résultat de la vérification par le dispositif de vérification distant, dans lequel en fonction du résultat, les signaux d'initialisation générés sont sortis ou les données d'initialisation sont révisées sur la base du résultat de sorte que des signaux d'initialisation révisés sont générés et sortis qui représentent les données d'initialisation révisées.

10. Dispositif (201) qui est conçu pour exécuter toutes les étapes du procédé selon l'une quelconque des revendications précédentes.

11. Châssis roulant (401, 501), comprenant le dispositif (201) selon la revendication 10.

12. Carrosserie (503, 505), comprenant le dispositif (201) selon la revendication 10.

13. Véhicule automobile (507, 509), comprenant un agencement composé d'un châssis roulant (401, 501) et d'une carrosserie (503, 505) disposée sur le châssis roulant (401, 501) et le dispositif (201) selon la revendication 10.

14. Programme informatique (303), comprenant des instructions qui, lorsque le programme informatique (303) est exécuté par un ordinateur, font que celui-ci exécute un procédé selon l'une quelconque des revendications 1 à 9.

15. Support de stockage lisible par machine (301) sur lequel est stocké le programme informatique (303) selon la revendication 14.
